# DEMANDE DE BREVET EUROPEEN

(11) **EP 1 833 092 A1**
(43) Date de publication de la demande: **12.09.2007**
(21) Numéro de dépôt: 07103611.5
(22) Date de dépôt: 06.03.2007
(51) Int. Cl.: H01L 27/146

(54) **Capteur d'images comprenant des pixels à un transistor**

(30) Priorité: 06.03.2006 FR 0650765
(71) Demandeur: ST MICROELECTRONICS S.A., 92120 Montrouge (FR)
(72) Inventeur: Tournier, Arnaud, 38000 Grenoble (FR); Roy, François, 38180 Seyssins (FR)
(74) Mandataire: de Beaumont, Michel

(57) **Abrégé**

L'invention concerne un pixel comportant un transistor de type MOS (T1, T2) formé dans et au-dessus d'un substrat semiconducteur (1) d'un premier type de dopage, une couche semiconductrice enterrée (30) du second type de dopage étant placée dans le substrat sous le transistor MOS et séparée de ce dernier par une portion de substrat formant un caisson (33, 34), dans lequel la couche semiconductrice enterrée comporte une portion mince constituant une zone de pincement (301, 302) placée sensiblement sous la zone de canal du transistor et une portion épaisse placée sous tout ou partie des zones de source/drain du transistor.

## Description

### Domaine de l'invention

La présente invention concerne des pixels de capteurs d'images et plus particulièrement des pixels comprenant des éléments formés dans un substrat semiconducteur tel qu'une plaquette de silicium.

### Exposé de l'art antérieur

Un exemple de pixel formé en surface d'un substrat semiconducteur est décrit dans le brevet américain 6 448 596 de la société Innotech Corporation. Le pixel comprend une photodiode et un transistor MOS à canal N (NMOS). Comme cela est visible en figure 4A de ce brevet, reproduite en figure 1 de la présente demande, le transistor comprend une grille annulaire 59, une zone de source de type N 56 formée en surface du substrat à l'intérieur de la grille et une zone de drain de type N 57a formée autour de la grille. La photodiode est constituée d'une extension 57 de la zone de drain du transistor, d'une zone de caisson 54a placée sous l'extension 57 et d'une couche enterrée 52a placée sous cette zone de caisson.

Des photons incidents arrivant par une ouverture 63 d'une couche métallique réfléchissante 62 placée au-dessus du pixel génèrent des paires électrons-trous au niveau de la zone de caisson 54a. Les trous ainsi formés sont collectés sous la grille du transistor NMOS dans des poches fortement dopées de type P 55. Lors d'une phase de lecture, on détecte les modifications des caractéristiques de conduction électrique du transistor en fonction de la quantité de trous stockés sous la grille. Les trous accumulés sous la grille sont régulièrement "évacués" par application de tensions élevées sur la grille et sur les zones de source/drain du transistor.

Un inconvénient de ce pixel est qu'il occupe une importante surface de substrat, en raison notamment de la présence de la photodiode.

De plus, les pixels doivent être isolés les uns des autres par des zones semiconductrices dopées N 53 entourant les pixels, ce qui contribue également à l'augmentation de la surface du capteur.

En outre, le processus de fabrication de ce pixel est complexe.

### Résumé de l'invention

Un objet de la présente invention est de prévoir un pixel de capteur d'images qui occupe une faible surface d'un substrat semiconducteur.

Un autre objet de la présente invention est de prévoir un tel pixel facile à réaliser.

Pour atteindre ces objets, la présente invention prévoit un pixel comportant un transistor de type MOS formé dans et au-dessus d'un substrat semiconducteur d'un premier type de dopage, une couche semiconductrice enterrée du second type de dopage étant placée dans le substrat sous le transistor MOS et séparée de ce dernier par une portion de substrat formant un caisson, dans lequel la couche semiconductrice enterrée comporte une portion mince constituant une zone de pincement placée sensiblement sous la zone de canal du transistor et une portion épaisse placée sous tout ou partie des zones de source/drain du transistor.

Selon un mode de réalisation du pixel susmentionné, ladite zone de pincement est placée dans la partie supérieure de la couche semiconductrice enterrée, à proximité de la surface du substrat.

Selon un mode de réalisation du pixel susmentionné, une zone isolante placée dans la partie supérieure du substrat entoure les zones de source/drain et la zone de canal du transistor, ladite portion épaisse de la couche semiconductrice entourant la zone de pincement et se prolongeant sous la zone isolante.

Selon un mode de réalisation du pixel susmentionné, une zone réservoir du même type de dopage que le substrat semiconducteur mais plus dopée que celui-ci est placée au niveau de la zone de canal, en surface du substrat.

Selon un mode de réalisation du pixel susmentionné, le transistor comprend une grille isolée placée au-dessus du substrat semiconducteur, les zones de source/drain étant placées de part et d'autre de la grille dans la partie supérieure du substrat, la partie surfacique du substrat située entre les zones de source/drain sous la grille constituant ladite zone de canal.

Selon un mode de réalisation du pixel susmentionné, la grille et les zones de source/drain du transistor ainsi que la couche semiconductrice enterrée sont reliées à des lignes conductrices placées au-dessus du substrat, ledit caisson étant flottant.

La présente invention prévoit en outre un capteur d'images comprenant des pixels tels que ceux susmentionnés, dans lequel les couches semiconductrices enterrées des pixels constituent une même et unique couche semiconductrice enterrée.

Selon une variante de réalisation du capteur susmentionné, lesdites zones isolantes des pixels séparent les transistors des pixels les uns des autres, la profondeur des zones isolantes étant inférieure à celle des caissons des pixels.

Selon une variante de réalisation du capteur susmentionné, les caissons d'un ensemble de pixels s'étendent sous les zones isolantes entourant les transistors de ces pixels, les caissons de cet ensemble de pixels étant accolés les uns aux autres.

De plus, la présente invention prévoit un procédé de formation d'un pixel comprenant les étapes suivantes : former, dans un substrat semiconducteur d'un premier type de dopage, une zone isolante entourant une partie supérieure du substrat dite zone active ; former, dans le substrat semiconducteur, une couche semiconductrice enterrée d'un second type de dopage ; former une poche semiconductrice enterrée profonde du premier type de dopage par implantation ionique dans une partie inférieure de la couche enterrée, d'où il résulte que l'épaisseur de la couche enterrée est réduite au-dessus de cette poche enterrée, la poche enterrée étant placée sensiblement à l'aplomb d'une bande centrale de la zone active destinée à former une zone de canal ; former une grille isolée au-dessus de la bande centrale de la zone active ; former des zones de source/drain du second type de dopage dans la zone active, de part et d'autre de la grille.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est un schéma précédemment décrit d'un pixel connu ;
la figure 2 est une vue en coupe d'une partie d'un capteur selon la présente invention ;
la figure 3 est un schéma électrique d'une matrice de pixels d'un exemple de capteur selon la présente invention ;
la figure 4 est un diagramme indiquant les variations de potentiel dans un pixel du capteur représenté en figure 2, entre la surface et une partie interne du substrat ;
la figure 5 est un diagramme indiquant les variations de potentiel à travers les caissons des pixels du capteur représenté en figure 2 ; et
les figures 6A, 6B, 6C et 6D sont des vues en coupe de structures obtenues après des étapes successives d'un procédé de fabrication d'un capteur d'images comprenant des pixels selon la présente invention.

### Description détaillée

Par souci de clarté, de mêmes éléments ont été désignés par de mêmes références aux différentes figures et, de plus, comme cela est habituel dans la représentation des circuits intégrés, les figures ne sont pas tracées à l'échelle.

Un pixel selon la présente invention comprend un transistor MOS formé dans et au-dessus d'un susbstrat semiconducteur. Une couche semiconductrice enterrée d'un type de dopage opposé à celui du substrat est placée dans le substrat sous le transistor. Selon un aspect de la présente invention, la couche enterrée comporte une portion mince constituant une zone de pincement placée sous la zone de canal du transistor.

La structure et le fonctionnement d'un tel pixel sont décrits plus en détail ci-après à partir d'un exemple de capteur d'images comprenant des pixels selon la présente invention.

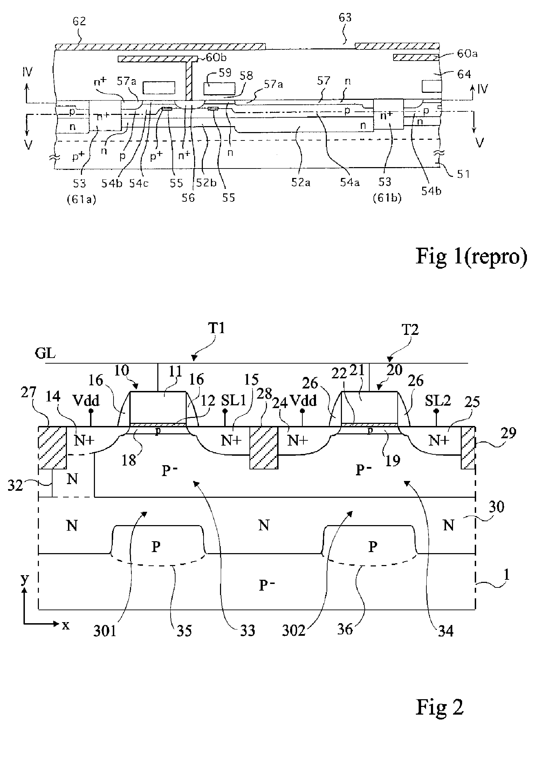

La figure 2 est une vue en coupe d'un exemple de capteur d'images comprenant deux pixels selon la présente invention. Le capteur est formé dans un substrat semiconducteur 1, faiblement dopé de type P dans cet exemple. Chaque pixel comprend un transistor NMOS T1, T2. Chaque transistor comporte une grille 10, 20 constituée d'une portion conductrice 11, 21 placée sur le substrat et isolée de ce dernier par une portion isolante 12, 22. Chaque transistor comprend en outre une zone de drain 14, 24 et une zone de source 15, 25 fortement dopées de type N formées en surface du substrat de part et d'autre de la grille 10, 20. Des espaceurs isolants 16, 26 sont formés contre les flancs des grilles 10, 20. On notera que les zones de source 15, 25 et de drain 14, 24 comprennent dans cet exemple, de minces extensions faiblement dopées de type N placées sous les espaceurs isolants 16 et 26. Par ailleurs, la partie surfacique du substrat placée entre les zones de source et de drain de chaque transistor T1, T2, sous sa grille, constitue une zone de canal.

Les pixels du capteur et plus précisément les transistors T1, T2 sont isolés les uns des autres par des zones isolantes peu profondes. Des portions 27, 28, 29 de ces zones isolantes sont représentées en figure 2, respectivement sur la gauche de la zone de drain 14 du transistor T1, entre la zone de source 15 du transistor T1 et la zone de drain 24 du transistor T2 et sur la droite de la zone de source 25 du transistor T2.

Une couche semiconductrice enterrée 30 dopée de type N est placée dans le substrat P 1 sous les transistors T1, T2. Une zone d'accès 32 dopée de type N est placée dans le substrat 1 entre la zone de drain 14 et la couche enterrée 30 afin de permettre une polarisation électrique de cette dernière. Les portions de substrat placées entre les transistors T1, T2 et la zone enterrée N 30 constituent des caissons 33 et 34. Les caissons 33 et 34 sont accolés l'un à l'autre sous la zone isolante 28 séparant les transistors T1, T2 des deux pixels représentés.

Selon un aspect de la présente invention, la couche enterrée 30 est plus mince sous les zones de canal des transistors T1, T2 des pixels du capteur. Les portions plus minces de la couche enterrée 30 constituent des zones de "pincement" 301 et 302. Les zones de pincement 301 et 302 sont de préférence situées sur le haut de la couche enterrée 30 au plus près des transistors T1 et T2. La fonction des zones de pincement est décrite plus en détail dans la suite de la description.

Dans l'exemple de capteur d'images représenté en figure 2, des portions de substrat 35, 36, situées au niveau des renfoncements de la couche enterrée 30, sous les zones de pincement 301 et 302, sont légèrement plus dopées que le substrat 1.

Des zones "réservoir" de type P 18 et 19, plus dopées que le substrat 1, sont formées en surface du substrat 1 sous les grilles 10 et 20 au niveau des zones de canal des transistors. L'épaisseur des zones réservoir 18 et 19 est sensiblement identique à celle des extensions faiblement dopées des zones de source/drain des transistors T1, T2.

Les transistors T1, T2 de chacun des pixels sont reliés à des lignes conductrices placées au-dessus du substrat 1 dans une ou plusieurs couches isolantes recouvrant le substrat et les grilles des transistors T1, T2. Les portions conductrices 11, 21 des grilles 10, 20 sont connectées à une ligne de grille GL. Les zones de source 15 et 25 sont connectées respectivement à des lignes de source SL1 et SL2. Les zones de drain 14 et 24 sont reliées à une tension d'alimentation Vdd.

On notera que la couche enterrée 30 est polarisée, dans l'exemple représenté en figure 2, par l'intermédiaire de la zone d'accès 32 et de la zone de drain 14 reliée à la tension d'alimentation Vdd. Les caissons 33 et 34 sont quant à eux "flottants", c'est-à-dire non polarisés directement par une source de tension. Les caissons 33 et 34 sont polarisés par divers couplages capacitifs avec la couche enterrée N 40 et les éléments des transistors T1 et T2.

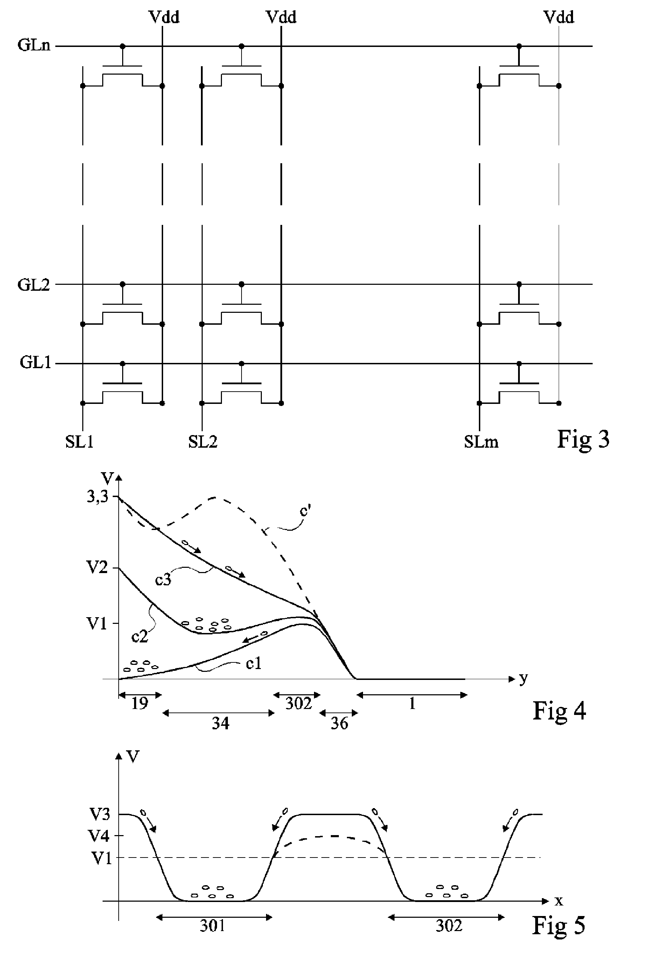

La figure 3 est un schéma illustrant un exemple de capteur d'images comprenant un ensemble de pixels organisés sous la forme d'une matrice constituée de n rangées et de m colonnes de pixels. Seuls les transistors de chaque pixel sont représentés. Les grilles des transistors des pixels de la i-ième rangée, i étant compris entre 1 et n, sont reliées à une ligne de grille GLi. Les zones de source des transistors des pixels de la j-ième colonne, j étant compris entre 1 et m, sont reliées à une ligne de source SLj. Les zones de drain des transistors sont reliées à la tension Vdd. Les lignes de grille GL1 à GLn sont reliées à un circuit de commande. Les lignes de source SL1 à SLm sont reliées à un circuit de lecture.

Le fonctionnement du capteur d'images décrit ci-dessus dépend de son utilisation, selon par exemple qu'il est utilisé comme caméra vidéo ou comme appareil photo. Cependant, quelle que soit son utilisation, chaque pixel du capteur effectue une séquence d'opérations de trois types : intégration, lecture et réinitialisation. Ces opérations sont décrites ci-après pour le pixel du capteur représenté à droite de la figure 2 et comprenant le transistor T2.

Lors d'une opération d'intégration, le pixel "capture" des photons incidents arrivant dans la partie supérieure du substrat 1 au niveau du caisson 34. La ligne de grille GL est alors polarisée à une faible tension, par exemple la masse. La ligne de source SL2 reliée à la zone de source 25 est en haute impédance ou polarisée à un potentiel au moins égal au potentiel du caisson 34 afin que la diode PN formée par le caisson P 34 et la zone de source 25, ne soit pas conductrice. Lorsqu'un photon est "capturé", il génère une paire électron-trou dans le caisson 34 ou dans une des zones de charges d'espace formées aux interfaces entre le caisson P 34 et la couche enterrée N 30 ou les zones des source/drain N 24, 25. Les trous des paires électron-trou ainsi formées se dirigent "naturellement" vers la zone de potentiel le plus faible, c'est-à-dire vers la zone réservoir P 19 située sous la grille 20. Les électrons se dirigent vers la couche enterrée N 30 ou les zones de source/drain 24 et 25. En résumé, lors de cette opération d'intégration, on accumule des trous dans la zone réservoir 19.

On notera que la capture de photons au niveau des caissons des pixels n'est possible que si les photons peuvent accéder à ces caissons. Il faut donc que la ou les couches isolantes recouvrant le substrat soient transparentes. De plus, il ne faut pas que les zones de source/drain et les grilles des transistors constitutifs des pixels soient siliciurées comme cela est fréquent. En outre le matériau de grille est de préférence choisi le moins "absorbant" possible, ou autrement dit le plus transparent possible, afin que des photons arrivant au niveau d'une grille puissent traverser cette dernière pour parvenir jusqu'au substrat. Un exemple de matériau de grille particulièrement transparent est l'oxyde d'Indium dopé au zinc (ITO) .

Lors d'une phase de lecture, on polarise la ligne de grille GL à une tension Vm permettant de rendre conducteur le transistor T2. La tension Vm est par exemple égale à 2 V dans le cas où la tension d'alimentation Vdd du capteur est de 3,6 V. Le circuit de lecture relié à la ligne de source SL2 comprend par exemple une source de courant "fixant" un courant à travers la ligne SL2 et par conséquent à travers le transistor T2. Le potentiel de la zone de source 25 est alors fonction de la quantité de trous stockés dans la zone réservoir 19 du transistor. Plus le nombre de trous stockés est important, plus le potentiel de la zone de source, et par conséquent celui de la ligne de source SL2, est élevé. Le circuit de lecture comprend un dispositif d'évaluation, tel qu'un convertisseur analogique-numérique, qui définit une valeur d'intensité lumineuse reçue par le pixel en fonction de la valeur de potentiel relevée sur la ligne de source SL2.

Lors d'une phase de réinitialisation, on polarise la ligne de grille GL et la ligne de source SL2 à la tension d'alimentation Vdd. Les trous stockés dans la zone réservoir 19 se dirigent alors vers le substrat 1 en passant à travers la zone de pincement 302. La zone réservoir 19 se vide.

La figure 4 est un diagramme indiquant les variations de potentiel à travers le pixel du capteur représenté sur la droite de la figure 2 entre la zone réservoir 19 et la portion de substrat P 36 située sous la zone de pincement 302. Trois courbes de potentiels c1, c2 et c3 sont représentées pour chacune des opérations suivantes : intégration, lecture et réinitialisation.

Par ailleurs, une courbe en pointillés c' représente les variations de potentiel à travers ce même pixel, à l'aplomb de la zone de source 24, en passant à travers une portion "épaisse" de la couche enterrée N 30. La courbe c' est sensiblement identique quelle que soit l'opération effectuée.

On notera que le potentiel de la zone de pincement 302 varie peu et qu'il est toujours bien inférieur au potentiel interne d'une portion épaisse de la couche enterrée N 30. Cette différence de potentiel est due au fait que la zone de pincement 302 est entièrement déplétée contrairement à une portion épaisse de la couche enterrée N 30. A titre indicatif, quand le substrat 1 est à la masse et que la couche enterrée N 30 est reliée à une tension Vdd de l'ordre de 3,3 V, la valeur de potentiel de la zone de pincement 302 est de l'ordre de 1 V. Cette dernière fluctue légèrement selon les opérations effectuées.

Lors d'une opération d'intégration (courbe c1), le potentiel dans la zone réservoir 19, à proximité de la grille 20, est sensiblement nul. Le potentiel augmente ensuite progressivement à travers la zone réservoir 19 et le caisson 34 jusqu'à atteindre une valeur maximale V1 au milieu de la zone de pincement 302. Le potentiel diminue ensuite progressivement à travers la portion de substrat P 36, entre la zone de pincement 302 et le substrat 1.

On notera que le potentiel des zones P supérieures, c'est-à-dire de la zone réservoir 19 et du caisson 34, évolue au fur et à mesure que des trous sont stockés. Le potentiel de ces zones P supérieures augmente progressivement avec l'arrivée de trous. Dans le cas où un pixel reçoit beaucoup de photons lumineux, il est possible que le potentiel de ces zones P supérieures atteigne la valeur de potentiel V1 de la zone de pincement 302. Dans ce cas, des trous "en excès" dans les zones P supérieures se dirigent naturellement vers le substrat 1 en passant à travers la zone de pincement 302. Le nombre de trous stockés est ainsi plafonné et le potentiel des zones P supérieures ne dépasse pas la valeur V1 lors d'une opération d'intégration.

De façon générale, la présence d'une zone de pincement dans chaque pixel permet de "plafonner" le potentiel de la zone réservoir et du caisson de ce pixel à une valeur de potentiel correspondant sensiblement au potentiel V1 de la zone de pincement. Cette caractéristique permet d'éviter des phénomènes "d'éblouissement", plus connus sous leur nom anglais de "blooming", consistant en une perturbation d'une opération de lecture d'une rangée de pixels du fait d'une opération d'intégration simultanée par d'autres pixels fortement éclairés. En pratique, si le potentiel du caisson P d'un pixel en phase d'intégration peut augmenter jusqu'à une valeur de potentiel supérieure à la valeur de potentiel présente sur la ligne de source SL reliée à ce pixel alors la diode PN formée par le caisson P et la zone de source de ce pixel peut devenir conductrice et perturber l'opération de lecture en cours. Afin d'éviter des phénomènes d'éblouissements dans un capteur comprenant des pixels selon la présente invention, il suffit de prévoir un circuit de lecture tel que le potentiel de chaque ligne de source ne puisse descendre en dessous de la valeur de potentiel V1. Le potentiel V1 étant bien inférieur à la tension d'alimentation Vdd du capteur, l'homme de l'art pourra aisément réaliser un tel circuit de lecture.

Lors d'une opération d'intégration (courbe c2), le potentiel dans la zone réservoir 19, à proximité de la grille 20, est égal à une valeur V2 supérieure à V1. Le potentiel V2 est dans cet exemple égal à 2 V. Le potentiel diminue ensuite rapidement en s'écartant de la grille 20 pour atteindre un minimum dans le caisson 34, de l'ordre de 0,8 V dans cet exemple. Le potentiel remonte ensuite progressivement jusque dans la zone de pincement 302 puis diminue de nouveau en allant vers le substrat 1. On notera que les trous stockés ne sont plus confinés à proximité de la grille mais "s'accumulent" dans le caisson 34.

Lors d'une opération de réinitialisation (courbe c3), le potentiel dans la zone réservoir 19, à proximité de la grille 20, est sensiblement égal à la tension d'alimentation Vdd, soit 3,3 V dans cet exemple. Le potentiel décroît ensuite progressivement en s'éloignant de la grille. En conséquence, les trous préalablement stockés dans la zone réservoir 19 se dirigent vers le substrat 1.

On notera que la présence d'un abaissement de potentiel dans la couche enterrée N au niveau de la zone de pincement 302 permet de faciliter l'évacuation des trous. En effet, si il n'y avait pas de zone de pincement 302 sous la zone réservoir 19, l'évacuation des trous à travers la couche enterrée N 30 nécessiterait l'application de tensions très élevées sur la grille 20 et les zones de source 25 et de drain 24.

Un avantage d'un pixel selon la présente invention est que des tensions peu élevées, égales à la tension d'alimentation "standard" du capteur, peuvent être utilisées pour évacuer des trous accumulés sous la grille du transistor du pixel.

La figure 5 est un diagramme indiquant les variations de potentiel à travers les caissons 33, 34 des pixels du capteur représenté en figure 2. La courbe de potentiels représentée correspond aux potentiels relevés dans les parties inférieures des caissons 33, 34, situées au-dessous du niveau des zones d'isolement inter pixels 27, 28 et 29. La courbe représentée correspond aux potentiels relevés lors d'une opération d'intégration, les zones de source 15 et 25 étant reliées à la tension d'alimentation Vdd. Le potentiel dans les portions des caissons 33, 34 situées au-dessus des zones de pincement 301 et 302 est faible et proche de 0 V dans cet exemple. Le potentiel dans les portions des caissons 33, 34 situées au-dessus des portions épaisses de la couche enterrée N 30 est "élevé" et égal à V3, de l'ordre de 2 V dans cet exemple. Les "remontées" de potentiel au niveau périphérique des caissons 33, 34, sous les zones isolantes inter pixels 27, 28, 29, permettent de réaliser un isolement entre les zones de stockage de trous de pixels voisins. Ainsi, un trou généré dans un caisson d'un pixel sous une de ses zones de drain ou de source se dirige "naturellement" vers l'intérieur de ce caisson puis vers la zone réservoir située sous la grille de ce pixel. Il est ainsi inutile de prévoir des zones d'isolement inter-pixels 27, 28, 29 très profondes.

Un avantage d'un capteur selon la présente invention est que les transistors des pixels du capteur peuvent être séparés les uns des autres par des zones d'isolement peu profondes. Dans le cas où le capteur fait partie d'un circuit intégré incluant divers blocs réalisant diverses fonctions, les zones d'isolement séparant les pixels du capteur peuvent être identiques aux zones d'isolement "classiques" séparant des transistors "standard" des autres blocs du circuit intégré.

De façon générale, le potentiel des parties inférieures des caissons 33, 34 est majoritairement fixé par les couplages capacitifs entre ces caissons et la couche enterrée N 30. Ainsi, la courbe des potentiels dans les parties inférieures des caissons a une forme sensiblement identique à la courbe des potentiels à travers la couche enterrée N 30.

On notera cependant que le potentiel dans la partie inférieure d'un caisson dépend en outre des potentiels appliqués sur les éléments du transistor placé au-dessus. Ainsi, lors d'une opération de lecture, le potentiel d'une zone de source peut passer de la tension Vdd à une tension plus faible et entraîner une légère baisse de potentiel dans la portion de caisson périphérique située sous cette zone de source. Dans le cas où deux zones de source de deux transistors voisins sont situées à proximité, il est possible, lors d'une opération de lecture, que le potentiel dans les zones périphériques des caissons de ces pixels diminue pour passer d'une valeur de potentiel V3 à une valeur de potentiel V4. Si la valeur de potentiel V4 est inférieure à la valeur de potentiel V1, les trous stockés dans un pixel peuvent migrer vers le pixel voisin. Afin d'éviter de telles migrations, il faut soit restreindre l'influence capacitive des zones de source en évitant par exemple de trop grandes chutes de potentiels sur les lignes de source, soit prévoir un isolement plus important entre deux zones des sources proches, par exemple au moyen de zones de type N profondes s'étendant de la surface du substrat jusqu'à la couche enterrée N 30 et reliées à la tension Vdd.

Comme cela est décrit ci-dessus, les zones de pincement permettent d'éviter des phénomènes d'éblouissement lors d'opérations de lecture, d'utiliser des tensions peu élevées lors d'opérations de réinitialisation, et d'isoler des pixels voisins. La surface d'une zone de pincement 301, 302 en vue de dessus est sensiblement identique à celle de la zone de canal du transistor placé au-dessus. Cependant, cette surface de pincement peut être plus restreinte ou au contraire plus étendue. De façon générale, la surface d'une zone de pincement doit être suffisamment large pour que l'influence capacitive de la zone de pincement sur le caisson placé au-dessus soit significative et ne doit pas trop s'étendre sous les zones de source/drain du transistor placé au-dessus afin qu'un isolement inter-pixels soit possible en périphérie du caisson du pixel.

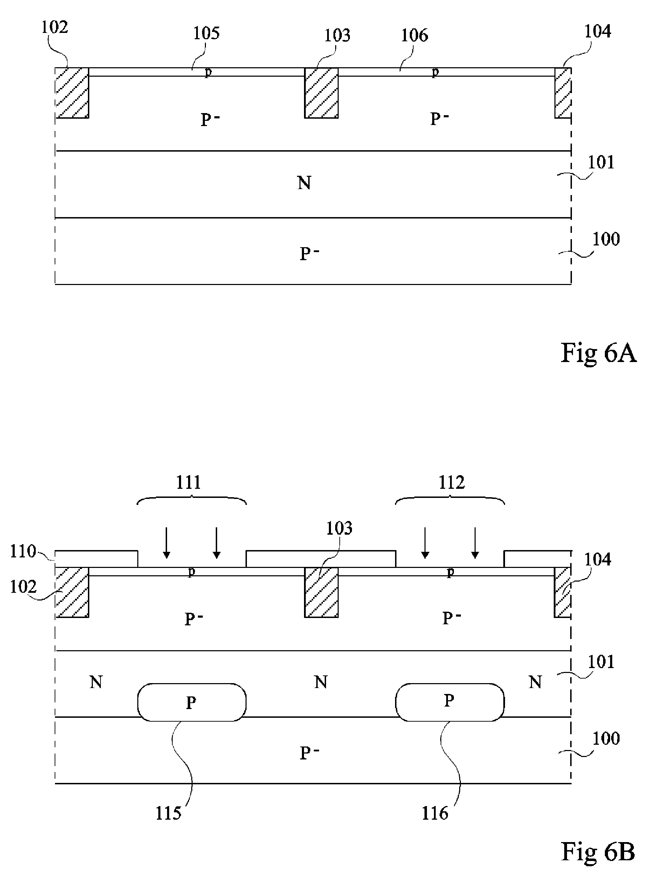

Un capteur d'images tel que celui représenté en figure 2 peut être obtenu pour le procédé décrit ci-après en relation avec les figures 6A à 6D. On comprendra que diverses régions dopées sont illustrées telles qu'elles apparaissent après des étapes de recuit qui ne sont pas décrites.

Dans une étape initiale, illustrée en figure 6A, on forme dans la partie supérieure d'un substrat faiblement dopé 100, par exemple de type P, des zones isolantes 102, 103, 104. En vue de dessus, les zones isolantes délimitent des portions supérieures de substrat constituant des zones actives de futurs transistors. On effectue ensuite une implantation ionique d'éléments dopants dans le substrat pour former une couche enterrée 101 dopée de type N. On effectue en outre une implantation ionique d'éléments dopants en surface des zones actives pour former de fines couches 105, 106 faiblement dopées de type P.

Lors d'une étape suivante, illustrée en figure 6B, on dépose une couche de résine photosensible 110 sur le substrat 100. On insole et on développe cette résine pour former des ouvertures 111, 112 dans cette dernière au-dessus de bandes centrales des zones actives destinées à former des zones de canal. On effectue ensuite une implantation ionique d'éléments dopants à forte énergie pour former des poches enterrées 115, 116 dopées de type P dans la partie inférieure de la couche enterrée N 101, sous les ouvertures 111 et 112. On élimine alors la couche de résine 110.

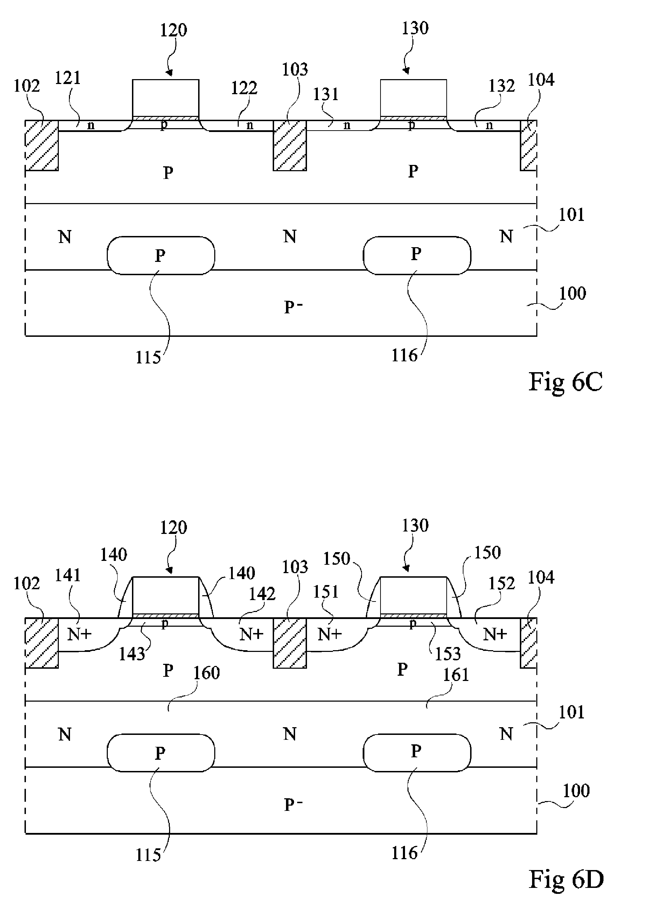

Lors d'une étape suivante, illustrée en figure 6C, on dépose, sur le substrat 100, une fine couche diélectrique, constituée par exemple d'oxyde de silicium, puis une couche conductrice, par exemple en silicium polycristallin. On effectue ensuite une gravure de ces deux couches de façon à former des grilles de transistor 120, 130 constituées chacune d'un empilement d'une portion isolante et d'une portion conductrice. On effectue ensuite une implantation ionique d'éléments dopants pour former des pré-zones de source 121, 131 et des pré-zones de drain 122, 132 faiblement dopées de type N en surface du substrat, de part et d'autre des grilles 120, 130.

Lors d'une étape suivante, illustrée en figure 6D, on forme des espaceurs isolants 140, 150 contre les flancs des grilles 120, 130. On effectue ensuite une implantation ionique d'éléments dopants dans la partie supérieure du substrat pour former des zones de source 141, 151 et de drain 142, 152 dopées de type N. Les portions restantes des couches P 105, 106 placées sous les grilles 120, 130 constituent des zones réservoir 143, 153. Les portions de la couche enterrée N 101 placées au-dessus des poches enterrées 115, 116 constituent des zones de pincement 160, 161.

Selon une variante du procédé susmentionné, préalablement à la formation des poches enterrées P 115, 116, on forme en surface du substrat une très fine couche dopée de type N de sorte qu'au final de fines zones N soient placées entre les grilles 120, 130 et les zones réservoir P 143, 153. Ces fines zones N facilitent l'évacuation des trous lors d'opérations de réinitialisation.

Par ailleurs, bien que non représentées en figures 6A à 6D, des zones d'accès de type N, telles que la zone d'accès 32 du capteur représenté en figure 2, peuvent être formées par implantation ionique d'éléments dopants dans le substrat 100. Cette implantation peut être effectuée après la formation de la couche enterrée 101.

En outre, on notera que les ouvertures 111, 112 et par conséquent les poches enterrées P 115, 116 peuvent être prévues plus larges ou au contraire plus restreintes que les zones réservoir P 143, 153 placées sous les grilles 120 et 130.

A titre indicatif, et non limitatif, les concentrations en éléments dopants, en atomes/cm³, dans les différentes parties du capteur représenté en figure 6D sont les suivantes :
substrat P 100 : 10¹⁷ ;
poches enterrées P 115, 116 : 3.10¹⁷ ;
couche enterrée N 101 : 2.10¹⁷ ;
poches réservoir 143, 153 : 2.10¹⁷ ;
zones de source et de drain 141/142/151/152 : 10²⁰.

De plus, toujours à titre indicatif et non limitatif, les dimensions des différentes parties du capteur représenté en figure 6D sont les suivantes :
épaisseur de la couche enterrée N 101 : 1 µm ;
profondeur des caissons (distance entre la surface du substrat et la couche enterrée N 101) : 1 µm ;
épaisseur des zones de pincement 160, 161 : 0,5 µm ;
profondeur des zones de source/drain 141, 142, 151, 152 : 0,3 µm ;
profondeur des zones isolantes 102-104 : 0,5 µm ;
épaisseur des zones réservoir 143, 153 : 0,1 µm.

On notera que les dimensions susmentionnées sont approximatives dans la mesure où les variations de concentrations entre deux zones de dopage différents sont progressives.

Bien entendu, la présente invention est susceptible de diverses variantes et modifications qui apparaîtront à l'homme de l'art. En particulier, on pourra réaliser des pixels dont les éléments semiconducteurs ont des dopages opposés à ceux des pixels représentés en figure 2. Un tel pixel comprendrait un transistor à canal P (PMOS) formé dans et au-dessus d'un substrat de type N comprenant une couche enterrée de type P, des zones réservoir de type P étant formées sous les grilles des transistors.

## Revendications

1. Pixel comportant un transistor de type MOS (T1, T2) formé dans et au-dessus d'un substrat semiconducteur (1) d'un premier type de dopage, une couche semiconductrice enterrée (30) du second type de dopage étant placée dans le substrat sous le transistor MOS et séparée de ce dernier par une portion de substrat formant un caisson (33, 34), **caractérisé en ce que** la couche semiconductrice enterrée comporte une portion mince constituant une zone de pincement (301, 302) placée sensiblement sous la zone de canal du transistor et une portion épaisse placée sous tout ou partie des zones de source/drain du transistor.

2. Pixel selon la revendication 1, dans lequel ladite zone de pincement (301, 302) est placée dans la partie supérieure de la couche semiconductrice enterrée (30), à proximité de la surface du substrat (1).

3. Pixel selon la revendication 1, dans lequel une zone isolante (27, 28, 29) placée dans la partie supérieure du substrat entoure les zones de source/drain (15, 25 ; 14, 24) et la zone de canal du transistor, ladite portion épaisse de la couche semiconductrice entourant la zone de pincement et se prolongeant sous la zone isolante.

4. Pixel selon la revendication 1, dans lequel une zone réservoir (18, 19) du même type de dopage que le substrat semiconductueur (1) mais plus dopée que celui-ci est placée au niveau de la zone de canal, en surface du substrat.

5. Pixel selon la revendication 1, dans lequel le transistor comprend une grille isolée (10, 20) placée au-dessus du substrat semiconducteur, les zones de source/drain (15, 25 ; 14, 24) étant placées de part et d'autre de la grille dans la partie supérieure du substrat, la partie surfacique du substrat située entre les zones de source/drain sous la grille constituant ladite zone de canal.

6. Pixel selon la revendication 5, dans lequel la grille (10, 20) et les zones de source/drain (15, 25, 14, 24) du transistor ainsi que la couche semiconductrice enterrée (30) sont reliées à des lignes conductrices placées au-dessus du substrat, ledit caisson (33, 34) étant flottant.

7. Capteur d'images comprenant des pixels selon l'une quelconque des revendications 1 à 6, dans lequel les couches semiconductrices enterrées (30) des pixels constituent une même et unique couche semiconductrice enterrée.

8. Capteur d'images selon la revendication 7 pris dans sa dépendance de la revendication 3, dans lequel lesdites zones isolantes (27, 28, 29) des pixels séparent les transistors des pixels les uns des autres, la profondeur des zones isolantes étant inférieure à celle des caissons (33, 34) des pixels.

9. Capteur d'images selon la revendication 8, dans lequel les caissons (33, 34) d'un ensemble de pixels s'étendent sous les zones isolantes (27, 28, 29) entourant les transistors de ces pixels, les caissons de cet ensemble de pixels étant accolés les uns aux autres.

10. Procédé de formation d'un pixel comprenant les étapes suivantes :
former, dans un substrat semiconducteur (100) d'un premier type de dopage, une zone isolante (102, 103, 104) entourant une partie supérieure du substrat dite zone active ;
former, dans le substrat semiconducteur, une couche semiconductrice enterrée (101) d'un second type de dopage ;
former une poche semiconductrice enterrée profonde (115) du premier type de dopage par implantation ionique dans une partie inférieure de la couche enterrée, d'où il résulte que l'épaisseur de la couche enterrée est réduite au-dessus de cette poche enterrée, la poche enterrée étant placée sensiblement à l'aplomb d'une bande centrale de la zone active destinée à former une zone de canal ;
former une grille isolée (120, 130) au-dessus de la bande centrale de la zone active ;
former des zones de source/drain (121, 131, 122, 132) du second type de dopage dans la zone active, de part et d'autre de la grille.
